# EUROPEAN PATENT APPLICATION

(11) **EP 3 674 598 A1**
(43) Date of publication of application: **01.07.2020**
(21) Application number: 19216721.1
(22) Date of filing: 16.12.2019
(51) Int. Cl.: F21S 4/28, F21V 15/015, F21V 27/02, F21V 23/00, F21Y 103/10, F21Y 115/10

(54) **STRIP LAMP**

(30) Priority: 29.12.2018 CN 201811653223
(71) Applicant: Self Electronics Co., Ltd., Ningbo City, Zhejiang 315103 (CN); SELF ELECTRONICS Germany GmbH, 51149 Köln (DE); Lin, Wanjiong, Ningbo City, Zhejiang 315103 (CN)
(72) Inventor: XUE, Yuanfang, Ningbo, 315103 (CN)
(74) Representative: 2K Patentanwälte Blasberg Kewitz & Reichel

(57) **Abstract**

The invention relates to a strip lamp, comprising strip lamp body, one end of the strip lamp body is provided with an outlet hole for the wire to protrude; end covers, sleeved on the outer periphery of the end of the strip lamp body and fastened thereto, and the end cover is provided with a through hole for the wire passing through, the through hole is disposed offset from the outlet hole, and a interval (D) is formed between the projection of the through hole on the plane of the outlet hole and the outlet hole; the end cover forms a line pressing mechanism extending toward an end of the strip lamp body on a side of the through hole adjacent to the outlet hole. The invention has the advantages of simple structure, remarkable anti-pull effect and good waterproof performance.

## Description

### RELATED APPLICATION

This application claims priority to a Chinese Patent Application No. CN 201811653223.2, filed on December 29, 2018.

### FIELD OF THE TECHNOLOGY

The present invention relates to optical field, with particular emphasis on a strip lamp.

### BACKGROUND OF THE INVENTION

Existing strip lamps often require an external connection line to be electrically connected to the internal motherboard of the lamp, but the connection line is easily pulled out, resulting in poor conduction of the lamp. In order to solve this problem, the designer generally designs a line pressing mechanism to fix the connecting line at the end of the lamp, but the line pressing mechanism usually requires more than two parts to meet the pressing line requirement, and the general line pressing operation is complicated and cumbersome.

Moreover, the lampshade lens of the existing strip lamp is not sealed with the base, and the glue seal is required to be waterproof, which not only increases the process, but also may result in an increase in the defect rate due to the failure of the glue seal to reach the standard, resulting in a decrease in efficiency.

### BRIEF SUMMARY OF THE INVENTION

In view of the above problems, an object of the present invention is to provide a strip lamp which is simple in line pressing mechanism but has a strong pressing line and good pull-proof effect.

it is also an object of the present invention to provide a strip lamp having a good waterproof effect.

In particular, a strip lamp, comprising strip lamp body, one end of the strip lamp body is provided with an outlet hole for the wire to protrude;
end covers, sleeved on the outer periphery of the end of the strip lamp body and fastened thereto, and the end cover is provided with a through hole for the wire passing through, characterized in that:
the through hole is disposed offset from the outlet hole, and a interval D is formed between the projection of the through hole on the plane of the outlet hole and the outlet hole;
the end cover forms a line pressing mechanism extending toward an end of the strip lamp body on a side of the through hole adjacent to the outlet hole , the line pressing mechanism applies a pressure toward the direction of the end of the strip lamp body to the wire located in the interval D to fix the wire.

Advantageously, the projection of the free end of the line pressing mechanism on the plane of the outlet hole forms a certain angle with the wire located in the interval D.
advantageously, the line pressing mechanism is a line pressing plate having a serrated shape at a free end.
advantageously, the included angle is 90 degrees.
advantageously, the line pressing mechanism is formed perpendicular to the inner wall of the end cover.

Advantageously, the line pressing plate has multiple elements(serrated) which are side-by-side spacing formed on the side of the end cover where the through hole is adjacent to the outlet hole.

Advantageously, the strip lamp body comprises a light transmitting component that internally accommodates an LED circuit board therein, and a lamp housing located outside the light transmitting component and fixedly connected thereto, the end surface of the lamp housing is flush with the end surface of the light transmitting component;
the light transmitting component includes a lens and a base integrally formed with the lens, the LED circuit board is positioned between the cavity formed by the lens and the base;
an opening is provided on a side surface of the lamp housing, and the light transmitting main portion of the lens is exposed outside the lamp housing from the opening.

Advantageously, the light transmitting component further includes a cover plate having a cross-sectional size adapted to the end surface of the light transmitting component and located at an end of the light transmitting component, and the outlet hole is formed on the cover plate.

advantageously, the end cover is fastened to the end surface of the lamp housing by screws.

Compared with the prior art, the invention has the advantages that: the end cover is provided with a through hole which is misaligned from the outlet hole of the strip lamp body, and the inner wall of the end cover is formed with a line pressing mechanism extending along the end of the strip lamp body, so the misalignment can make the wire to form a bent portion when passing through the through hole from the outlet hole, and the line pressing mechanism can apply a force to the bent portion toward the direction of the end of the strip lamp body to prevent the wire from being pulled out after the lamp is assembled. The combination of the line pressing mechanism and the misaligned through hole enables the lamp to have a good wire pull-out prevention function while reducing the line pressing parts, simplifies the structure, and improves the production efficiency; the lens and the base are integrally formed without glue sealing and waterproof, not only simplifies the process, but also greatly reduces the size of the lamp components, reducing the cost.

### BRIEF DESCRIPTION OF THE DRAWINGS

FIG. 1(a)-1(b) are schematic views showing the structure of different angles of the strip lamp of the present application.
FIG. 2(a)-2(c) are partial exploded views of different angle of the strip lamp of the present application.
FIG. 3 is a cross-sectional view of the strip lamp of the present application.
FIG.4 is another partial exploded view of the strip lamp of the present application.

### DETAILED DESCRIPTION OF THE INVENTION

the present application is illustrated by way of the following detailed description based on of the accompanying drawings. It should be noted that illustration to the embodiment in this application is not intended to limit the invention. The embodiments of the present invention are described in detail below, and the examples of the embodiments are illustrated in the drawings, wherein the same or similar reference numerals are used to refer to the same or similar elements or elements having the same or similar functions. The embodiments described below with reference to the accompanying drawings are intended to be illustrative of the invention and are not to be construed as limiting.

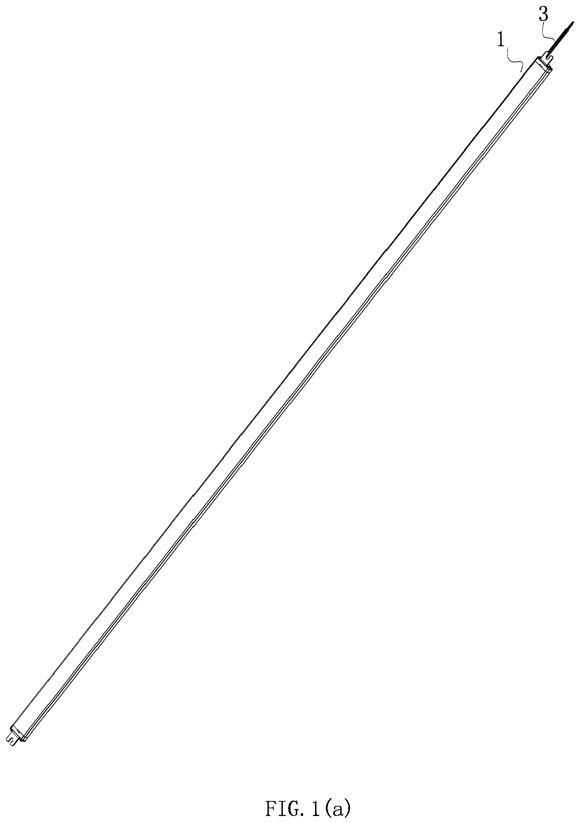

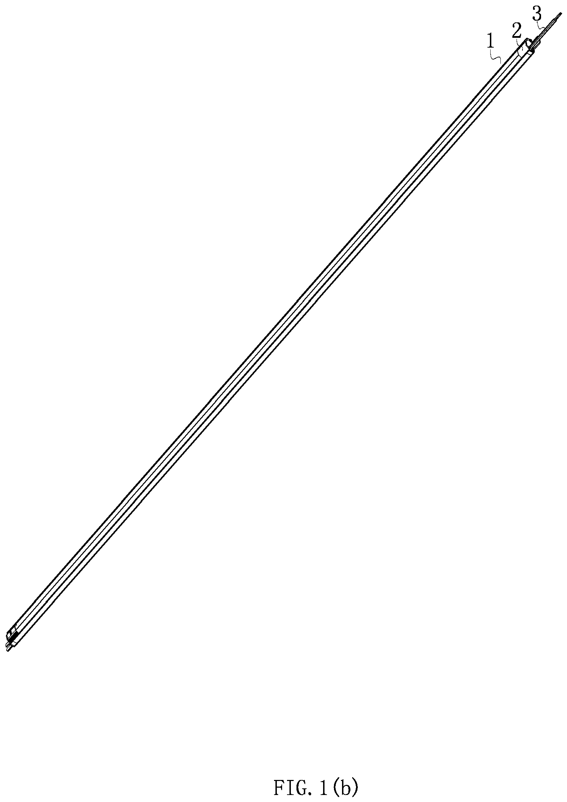

FIG. 1(a)-1(b), 2(a)-2(c) and 3-4 are schematic structural views of a preferred embodiment of the strip lamp of the present application. According to FIG. 1(a)-1(b) and FIG. 2(a)-2(c) and FIG. 3, the strip lamp comprises a strip lamp body 1 and end covers 2 sleeved on the outer periphery of the end of the strip lamp body 1 and connected to the strip lamp body 1, the end of the strip lamp body 1 is provided with an outlet hole 11 for the wire 3 to protrude, and the end cover 2 is provided with a through hole 21 for the wire 3 passing through.

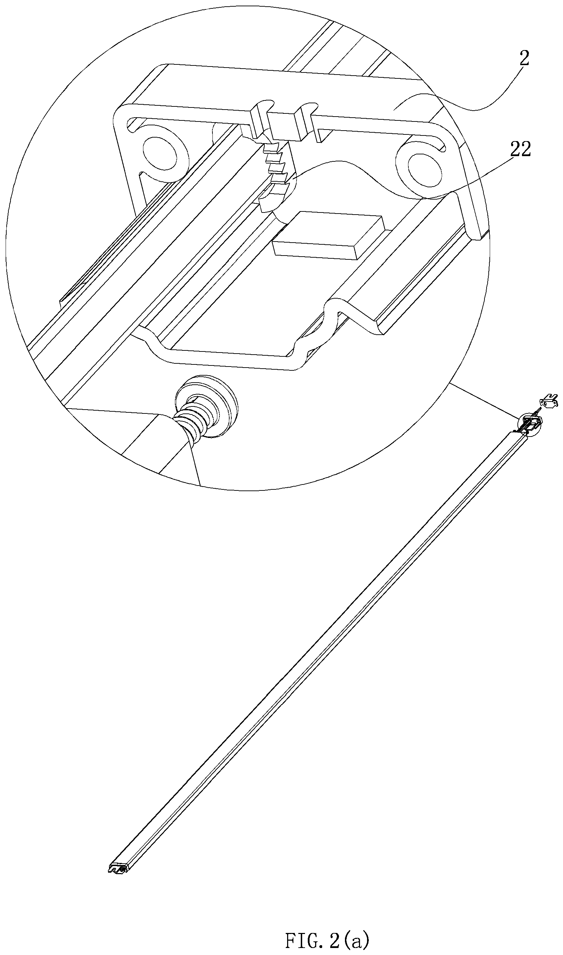

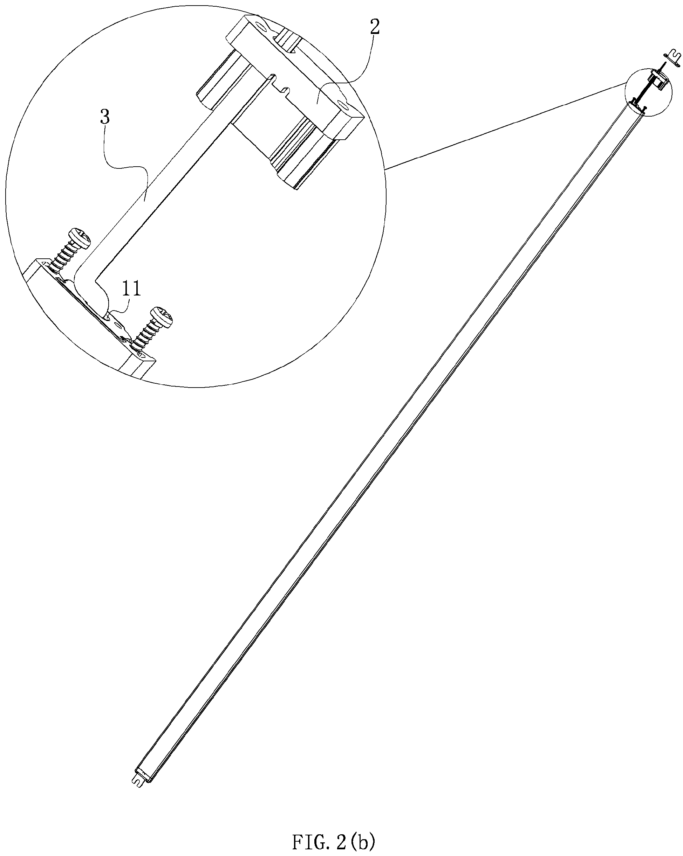

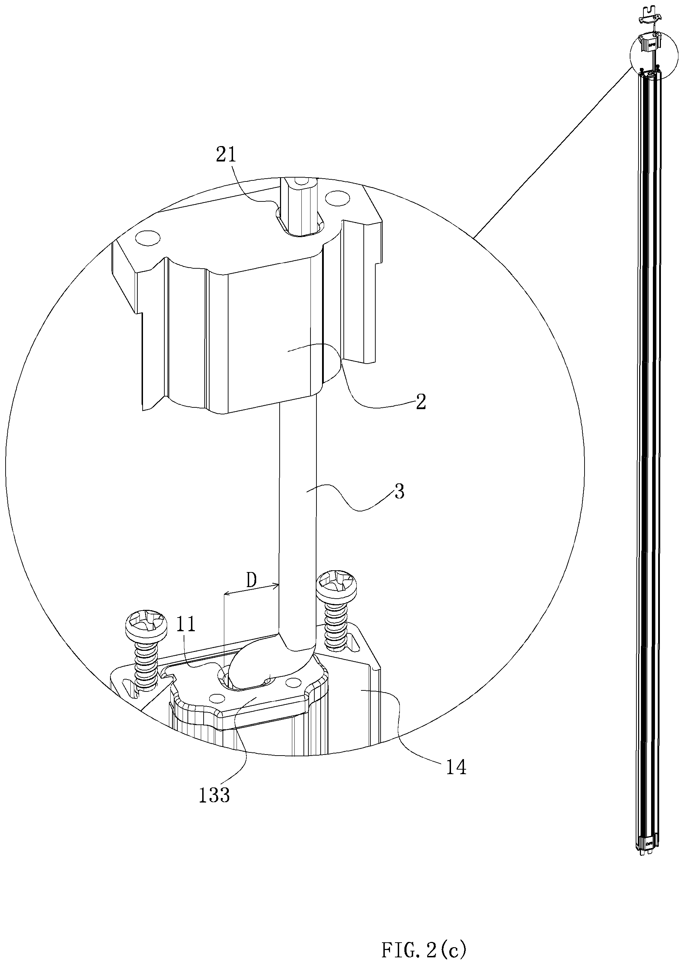

The through hole 21 is disposed offset from the outlet hole 11, meanwhile, a interval D between the projection of the through hole 21 on the plane of the outlet hole 11 and the outlet hole 11 is formed, as shown in FIG. 2(c), that is, the projection of the through hole 21 on the end of the strip lamp body 1 does not coincide with the outlet hole 11. The end cover 2 forms a line pressing mechanism 22 extending toward the end of the strip lamp body 1 on the side of the through hole 21 close to the outlet hole 11. The line pressing mechanism 22 can apply pressure toward the direction of the end of the strip lamp body 1 to the wire 3 located in the interval D to fix the wire 3 after the lamp assembly is completed.

specifically, in the embodiment, the wire 3 extends from the outlet hole 11 in parallel to the end of the strip lamp body 1. the through hole 21 on the end cover 2 is out of position with the outlet hole 11, when the wire 3 passes through the through hole 21, the wire 3 will deform, that is, a substantially bent portion is formed between the intervals D. When the end cover 2 continues to be pushed towards the end of the strip lamp body 1, the free end of the line pressing mechanism 22 on the inner wall of the end cover 2 will contact with the bent portion and squeeze the wire. The outer layer of the wire is wrapped with soft rubber layer, and the line pressing mechanism 22 will make the soft rubber layer sag during the process of squeezing the wire 3. When the end cover 2 and the strip lamp body 1 are tightened thoroughly, the line pressing mechanism 22 also squeezes the wire 3 to the maximum, which corresponds to the soft rubber layer sag to the maximum depth. When the wire 3 is pulled externally, since the free end of the line pressing mechanism 22 is embedded in the sag and finally positioned at the maximum depth to hold against the wire 3, the force applied to the wire 3 toward the direction of the end of the strip lamp body 1 hinders the movement of the wire 3, thereby restricting the wire 3 from falling out of the strip lamp body 1 to achieve the purpose of preventing pull-out.

Obviously, When the end cover 2 is completely fixed, the wire 3 finally forms a Z shape after bending in the interval D of the spacing, and the end of the line pressing mechanism 22 applies pressure to the portion of the z-shape located in the interval D, which can also be obtained from FIG.2 (c).Of course, the Z shape is only similar to the Z shape, because the bending deformation capacity of the wire itself, the size of the wire and the distance between the end cover and the end of the strip lamp body and other factors will limit the bending shape of the wire, Therefore, the wire may also eventually form a " 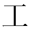 " shape, which can be easily understood and conceived by those skilled in the art according to the design structure of the present application, and therefore will not be explained here.

The dislocation arrangement between the hole and hole causes the wire to deform and form the bent portion, which ingeniously changes the direction of the external force acting on the wire and converts the force into a decomposing force that can move the deformation part, that is, the bent portion. The line pressing mechanism located inside the end cover can generate a force on the deformation part toward the end of the strip lamp body, which can well overcome the decomposing force, thereby utilizing the force interaction to subtly limit the wire movement, and the anti-pulling function can be easily realized. It is also based on this principle that the design can make the line pressing mechanism extremely simple, as long as it can exert a force on the deformed portion of the wire to hinder the movement of the deformed portion, and such a simplified design reduces component design and reduces production cost.

For example, the pressing mechanism may be a line pressing plate extending toward the end of the strip lamp body 1. In order to generate a sufficient restraining force on the deformed portion of the wire 3, the projection of the line pressing plate on the plane of outlet hole 11 is at a certain angle with the wire at the deformation position. Of course, the free end can also be substantially parallel with the deformation portion of the wire 3, but this kind of situation has higher requirements on the width design of the free end of the plate, and it is preferable to completely cover and press the deformation portion, thereby ensuring that the deformation portion has enough force to limit its movement.

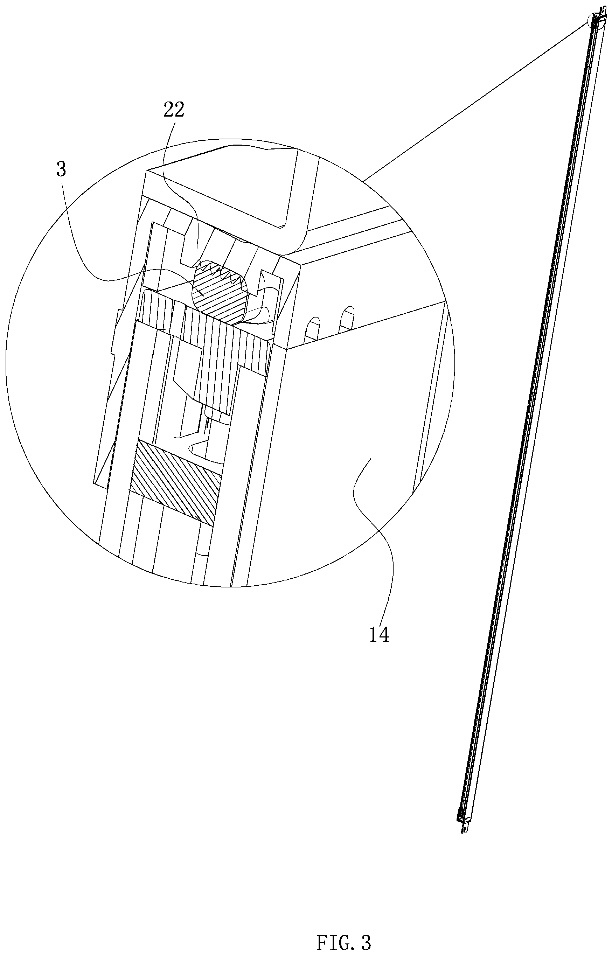

In order to ensure that the free end of the line pressing plate is in close contact with the deformation part of the wire, the free end is serrated, as shown in FIG.3. The serration can be firmly fitted to the surface of the wire 3 when the end cover 2 is fastened to the strip lamp body 1, thereby increasing the resistance to the wire 3.

It is conceivable that the included angle between the projection of the free end of the line pressing plate on the plane of the outlet hole 11 and the wire 3 between the interval D is different, then the force exerted by the line pressing plate on the wire 3 between the interval D is also unequal. Preferably, in the embodiment, the included angle is 90 degrees, that is, the free end surface corresponding to the line pressing plate is perpendicular to the wire 3 in the interval of the interval D, and the pressing plate is perpendicular to the inner wall of the end cover 2. Of course, the line pressing plate may have multiple sections and/or elements and/or serrated elements such as teeth which are side-by-side spacing formed on the side of the end cover 2 wherein the through hole 21 is close to the outlet hole 11.

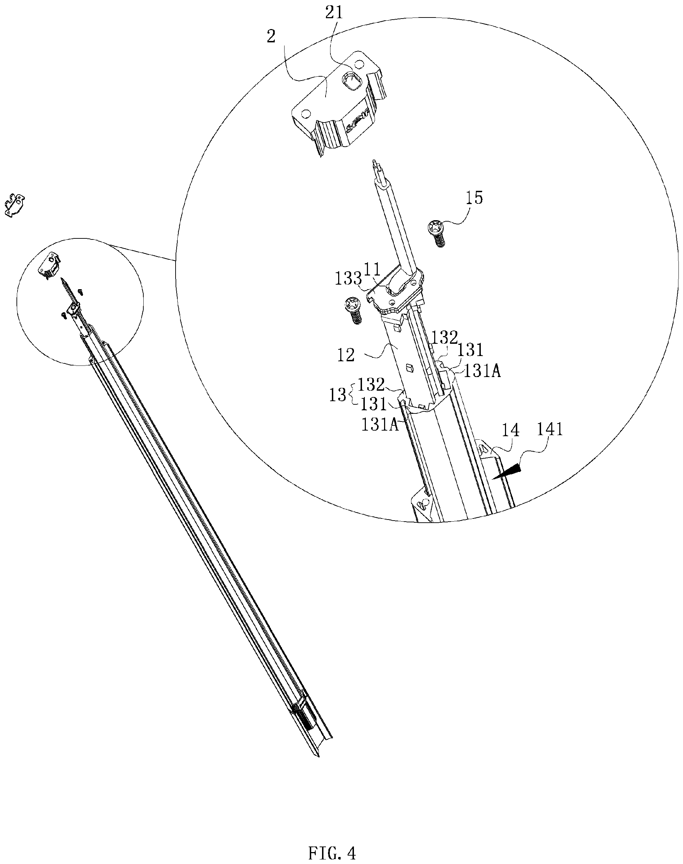

Referring to FIG.4, the strip lamp body 1 includes a light transmitting component 13 that can internally accommodate the LED circuit board 12 therein, and a lamp housing 14 that is located outside the light transmitting component 13 and fixedly connected thereto. The end surface of the lamp housing 14 is flush with the end surface of the light transmitting component 13, and the light transmitting component 13 includes a lens 131 and a base 132 integrally formed with the lens. The LED circuit board 12 is positioned between the cavity formed by the lens 131 and the base 132. An opening 141 is provided on a side surface of the lamp housing 14, and the light transmitting main portion 131A of the lens 131 is exposed outside the lamp housing 14 from the opening 141.

The lens is integrally formed with the base to achieve integrated waterproofing without the need for a glue seal to reduce the production process. At the same time, the one-piece design makes the lamp body greatly reduced in size under the condition of close performance, which can reduce the cost by about 30%, and the effect is remarkable.

The light transmitting component 13 further includes a cover plate 133 having a cross-sectional size that fits the end surface of the light transmitting component 13 and located at an end of the light transmitting component 13, and the outlet hole 11 is formed on the cover plate 133. The end cover 2 is fastened to the end surface of the lamp housing 14 by means of screws 15. When the screw 15 is not screwed, the end cover 2 does not have a tight connection with the strip lamp body 1, which means that the line pressing plate 22 has no pulling-proof effect on the wire 3, and only when the screw is tightened, the line pressing plate 22 can play the role of anti-pulling on wire 3. Such a design can simplify assembly and facilitate disassembly and maintenance.

The above disclosure has been described by way of example and in terms of exemplary embodiment, and it is to be understood that the disclosure is not limited thereto. Rather, any modifications, equivalent alternatives or improvement etc. within the spirit of the invention are encompassed within the scope of the invention as set forth in the appended claims.

## Claims

1. A strip lamp, comprising:
strip lamp body (1), one end of the strip lamp body (1) is provided with an outlet hole (11) for a wire (3) to protrude;
end covers (2), sleeved on the outer periphery of the end of the strip lamp body (1) and fastened thereto, and the end cover (2) is provided with a through hole (21) for the wire (3) passing through,
**characterized in that**:
the through hole (21) is disposed offset from the outlet hole (11), and a interval (D) is formed between the projection of the through hole (21) on the plane of the outlet hole (11) and the outlet hole (11); the end cover (2) forms a line pressing mechanism (22) extending toward an end of the strip lamp body (1) on a side of the through hole (21) adjacent to the outlet hole (11), the line pressing mechanism (22) applies a pressure toward the direction of the end of the strip lamp body (1) to the wire (3) located in the interval (D) to fix the wire (3).

2. The strip lamp as claimed in claim 1, wherein the projection of the free end of the line pressing mechanism (22) on the plane of the outlet hole (11) forms a predefined angle with the wire (3) located in the interval (D).

3. The strip lamp as claimed in claim 2, wherein the line pressing mechanism (22) is a line pressing plate having a serrated shape at a free end.

4. The strip lamp as claimed in claim 2 or 3, wherein the angle is 90 degrees.

5. The strip lamp as claimed in any of the claims 1 to 4, wherein the line pressing mechanism (22) is formed perpendicular to the inner wall of the end cover (2).

6. The strip lamp as claimed in any of the claims 3 to 5, wherein the line pressing plate has multiple serrated elements which are side-by-side and spaced formed on the side of the end cover (2) where the through hole (21) is adjacent to the outlet hole (11).

7. The strip lamp as claimed in any of the claims 1 to 6, wherein the strip lamp body (1) comprises a light transmitting component (13) that internally accommodates an LED circuit board (12) therein, and a lamp housing (14) located outside the light transmitting component (13) and fixedly connected thereto, the end surface of the lamp housing (14) is flush with the end surface of the light transmitting component (13);the light transmitting component (13) includes a lens (131) and a base (132) integrally formed with the lens (131), the LED circuit board (12) is positioned between the cavity formed by the lens (131) and the base (132); an opening (141) is provided on a side surface of the lamp housing (14), and the light transmitting main portion (131A) of the lens (131) is exposed outside the lamp housing (14) from the opening (141).

8. The strip lamp as claimed in claim 7, wherein the light transmitting component (13) further includes a cover plate (133) having a cross-sectional size adapted to the end surface of the light transmitting component (13) and located at an end of the light transmitting component (13), and the outlet hole (11) is formed on the cover plate (133).

9. The strip lamp as claimed in claims 7 and 8, wherein the end cover (2) is fastened to the end surface of the lamp housing (14) by screws (15).
